# EUROPEAN PATENT APPLICATION

(11) **EP 2 093 809 A2**
(43) Date of publication of application: **26.08.2009**
(21) Application number: 09151182.4
(22) Date of filing: 23.01.2009
(51) Int. Cl.: H01L 31/18, B23K 26/06

(54) **Solar module patterning apparatus.**

(30) Priority: 22.02.2008 KR 20080016220
(71) Applicant: Kisco, Changwon-si Gyeongsangnam-do 641-370 (KR)
(72) Inventor: An, Dae-Woon, 330-170, Chungcheongnam-do (KR); Lee, Seung-Hyun, 122-822, Seoul (KR); Myong, Seung-Yeop, 156-831, Seoul (KR)
(74) Representative: Zambardino, Umberto

(57) **Abstract**

A solar module patterning apparatus comprises a laser oscillator, a homogenizer, and a scanner. The laser oscillator generates a laser beam having a predetermined wavelength. The homogenizer homogenizes an intensity distribution of the generated laser beam provided from the laser oscillator. The scanner scans the laser beam to a solar module. The laser beam is output from the homogenizer and passed through a mask with a predetermined pattern.

## Description

### BACKGROUND

### Field

The embodiment relates to a solar module patterning apparatus.

### Description of the Related Art

A solar cell is an element converting solar energy into electrical energy, and may be divided into a silicon type, a chemical compound type, and an organic material type.

Silicon solar cells are subdivided into single crystalline silicon solar cells, polycrystalline silicon solar cells, and amorphous silicon-based solar cells according to their phase.

Moreover, the solar cell may be classified into a bulk (substrate) solar and a thin-film solar cell according to its thickness. In the silicon solar cell, the single crystalline silicon solar cell and the polycrystalline silicon solar cell belong to a bulk type, whereas the amorphous silicon-based solar cell belongs to a thin-film type.

Meanwhile, the chemical compound solar cell is classified into a bulk type consisting of Group III-V Gallium Arsenide (GaAs) and Group III-V Indium Phosphide (InP), and a thin-film type consisting of Group II-VI Cadmium Telluride (CdTe) and Group I-III-VI Copper Indium Diselenide (CIS; CulnSe2). The organic material solar cell is largely divided into an organic molecule type and organic/inorganic combination type. Besides these a photo electric chemical cell such as a dye-sensitized solar cell belongs to a thin-film type.

Among various types of solar cells, a bulk type silicon solar cell having a high energy conversion efficiency and a low manufacturing cost has been widely used for ground power units.

However, in recent years, in the increasing demand for a bulk type silicon solar cell, the cost thereof has rapidly increased due to lack of material. Consequently, so as to develop a cost effective mass production technology of a solar cell for large-scale ground power units, there is a significant need for the development of a thin-film solar cell capable of reducing silicon material consumption by 1/100 that of current consumption.

### SUMMARY

In one aspect, a solar module patterning apparatus comprises a laser oscillator generating a laser beam having a predetermined wavelength, a homogenizer homogenizing an intensity distribution of the generated laser beam provided from the laser oscillator and a scanner scanning the laser beam to a solar module, the laser bema being output from the homogenizer and passed through a mask with a predetermined pattern.

The solar module patterning apparatus may comprise a regulator controlling an intensity of the generated laser beam provided from the laser oscillator.

The solar module patterning apparatus may further comprise an fiber coupler connected to the regulator, an optical fiber connected to the fiber coupler and a fiber mount connected to the optical fiber and the homogenizer.

The solar module patterning apparatus may further comprise an regulator regulating an intensity of the generated laser beam provided from the laser oscillator and a beam expander converting the laser beam passed through the regulator into a parallel light, wherein the homogenizer homogenizes an intensity distribution of the generated laser beam provided from the beam expander.

The solar module patterning apparatus may further comprise a focusing lens compensating an image size error occurring due to an optical path difference of the laser beam passed through the scanner.

The solar module patterning apparatus may further comprises a stage on which the solar module is mounted to forming a pattern at the solar module by the laser beam passed through the scanner.

The solar module patterning apparatus may further comprise a stage on which the solar module is mounted to forming a pattern at the solar module by the laser beam passed through the scanner and a stage moving device moving the stage.

The solar module patterning apparatus may further comprise a focusing lens compensating an image size error occurring due to an optical path difference of the laser beam passed through the scanner, and wherein the focusing lens comprises telecentric lenses.

A galvanometer may be mounted in the scanner, and the laser beam may be scanned to the solar module through the galvanometer.

The solar module patterning apparatus may further comprise a scanner moving device moving the scanner.

The solar module patterning apparatus may further comprise a first total reflection mirror reflecting the laser beam passed through the mask in a predetermined direction and a second total reflection mirror reflecting the laser beam to be incident in the scanner.

The solar module patterning apparatus may further comprise a focusing lens compensating an image size error occurring due to an optical path difference of the laser beam passed through the scanner, and wherein the focusing lens may determine an image magnification of an image when the laser beam passed through the scanner is scanned on the solar module.

A plurality of pattern may be formed on the mask, and the laser beam may pass through one of the plurality of patterns by a rotation of the mask.

The laser beam may have a wavelength ranging from 1054 nm to 1074 nm or from 522 nm to 542 nm.

### BRIEF DESCRIPTION OF THE DRAWINGS

The embodiment will be described in detail with reference to the following drawings.

FIG. 1 is a view illustrating a construction of a solar module patterning apparatus in accordance with a first embodiment.

FIG. 2A and FIG. 2B are photographs illustrating an effect of a homogenizer.

FIG. 3 is a cross-sectional view illustrating a laminate structure of a thin-film solar cell of a prior art.

FIG. 4A to FIG. 4C are views illustrating patterns formed on a solar module by a laser beam having a Gaussian distribution.

FIG. 5 is a view illustrating available patterns in accordance with an embodiment.

FIG. 6A is a view illustrating a laser beam scanned on a substrate of a solar module through a galvanometer and a focusing lens.

FIG. 6B is a view illustrating a path of a laser beam scanned on a substrate of a solar module.

FIG. 7 to FIG. 10 are plan views illustrating a patterning direction and a patterning shape by the solar module patterning apparatus in accordance with an embodiment.

FIG. 11 is a schematic view illustrating a construction of a solar module pattering apparatus in accordance with a second embodiment.

### DETAILED DESCRIPTION OF EMBODIMENTS

Embodiments will be described in a more detailed manner with reference to the drawings.

[First embodiment]

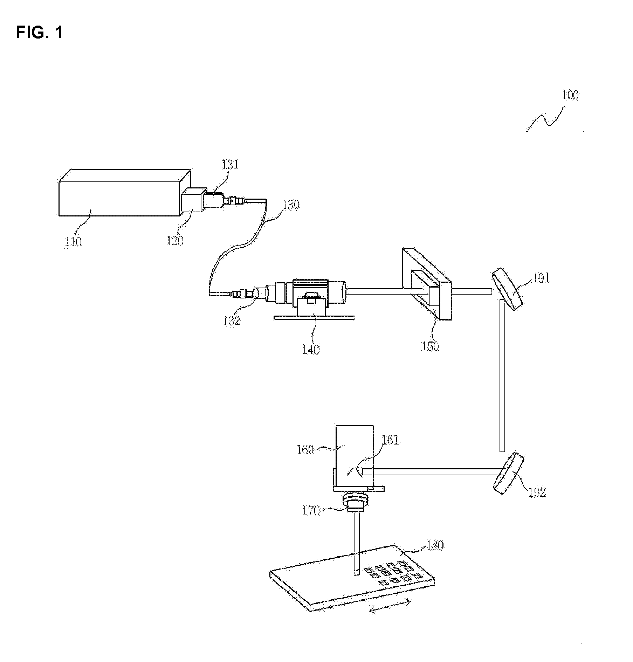

FIG. 1 is a view illustrating a construction of a solar module patterning apparatus in accordance with a first embodiment. As shown in FIG. 1, the solar module patterning apparatus 100 includes a laser oscillator 110, an regulator 120, an optical fiber 130, a homogenizer 140, a mask 150, first and second total reflection mirrors 191 and 192, a scanner 160, a focusing lens 170, and a stage 180.

The laser oscillator 110 generates a laser beam having a predetermined wavelength and energy, and emits the laser beam in a predetermined direction. A gas laser using a neutral atom, an ionized atom or molecule, a solid laser using a ruby or Nd-YAG, a liquid laser obtained by dissolving a color molecule such as rhodamine in an organic solvent, and a semiconductor laser using gallium arsenide (GaAs), a three-component alloy (GaAlAs) or a four-component alloy (InGaAsP) may be used as the laser source of the laser oscillator 110. However, a type of the laser is not limited thereto in the embodiment.

The regulator 120 is provided in one side of the laser oscillator 110. The regulator 120 regulates power or energy of the laser beam emitted by the laser oscillator 100 at an angle of an optical system. Accordingly, this adjusts transmittivity of the emitted laser beam, thereby minutely controlling an intensity of the laser beam to a specific reference value.

The optical fiber 130 transfers the laser beam provided from the regulator 120 to the homogenizer 140. The optical fiber 130 is connected with the regulator 120 through a fiber coupler 131. The fiber coupler 131 focuses the laser beam provided from the regulator 120 to a core of the optical fiber 130. The optical fiber 130 is connected to the homogenizer 140 through a fiber mount 132.

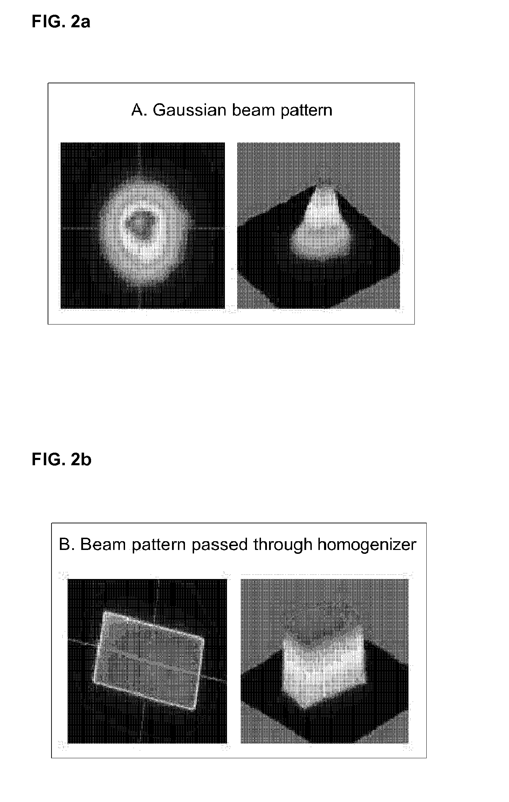

The homogenizer 140 homogenizes an intensity distribution of the laser beam provided from the optical fiber 130. The homogenizer 140 homogenizes an intensity distribution of the laser beam by a combination of spherical lenses. The homogenized intensity of the laser beam achieved by the homogenizer 140 is described with reference to FIG. 2A and FIG. 2B below.

A laser beam with a Gaussian intensity distribution shown in FIG. 2A passes through the homogenizer 140 in FIG. 1 to be converted into a laser beam with homogenized intensity distribution. Accordingly, the homogenization for the intensity distribution of the laser beam makes a profile of a p-i-n structure of a solar module etched by the laser beam uniform. Respective beam patterns shown in FIG. 2A and FIG. 2B were measured by a beam profiler. A solar module having the p-i-n structure comprises a p type silicon, an intrinsic silicon and a n type silicon which are deposited sequentially.

In the embodiment, the laser beam with the homogenized intensity distribution is incident on a solar cell layer laminated on a substrate of the solar module. This prevents a non-uniform pattern of the p-i-n structure occurring during manufacturing of building integrated photovoltaic (referred to as 'BIPV' hereinafter) modules.

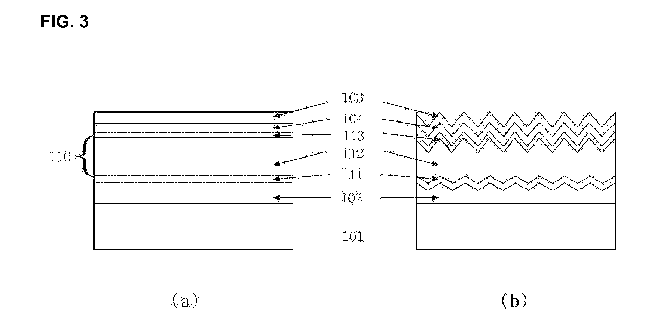

FIG. 3 is a cross-sectional view illustrating a laminate structure of a thin-film solar cell of a prior art. In FIG. 3(a), a transparent conductive oxide (TCO) 102 is formed on a transparent insulation substrate 101, and one solar cell layer 110 is formed on the TCO 102.

Further, in FIG. 3(b), the TCO 102 formed on the transparent insulation substrate 101 has a textured surface. One solar cell layer 110 is formed on the TCO 102 and is made of a silicon material.

The solar cell 110 in FIG. 3 comprises a p-layer 111, an i-layer 112, and an n-layer 113. In some cases, an buffer layer may be formed between the p-layer 111 and the i-layer 112, and a transparent back reflector 104 and a rear electrode layer 103 are sequentially deposited above the solar cell layer 110. In this case, the rear electrode layer 103 is made of a metal material. The p-layer 111 is doped with p type dopant such like group **III** element, and the n-layer 113 is doped with n type dopant such like group V element. The i-layer 112 is an intrinsic layer.

Moreover, a solar cell with a tandem cell structure such like a double junction cell or a triple junction cell consisting of two or more solar cells may be manufactured.

Meanwhile, since the solar cell in FIG. 3 is manufactured in a large area unit, it is difficult to adjust a transmissivity thereof. Accordingly, upon manufacturing the solar module, a laser beam is incident on the transparent insulation substrate 101 on which a solar cell is formed to etch the TCO 102, the solar cell layer 110, the transparent back reflector 104, and the rear electrode layer 103 made of a metal material, with the result that a pattern transmitting light is formed.

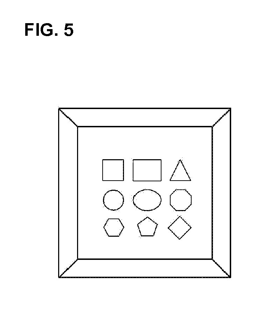

In particular, a solar module on which a pattern is formed together with a laminated structure in FIG. 5 is referred to as a 'BIPV module'.

Upon manufacturing the BIPV module, the solar module patterning apparatus in accordance with the embodiment may be used to etch the TCO 102, the solar cell layer 110, the transparent back reflector 104, the rear electrode layer 103 made of a metal material, and the like (referred to as 'solar cell layer and the like' hereinafter) in order to form a pattern transmitting light.

Namely, as shown in FIG. 2A, when an intensity of a laser beam used to manufacture the BIPV module has a Gaussian distribution, patterning is achieved in only area corresponding to a central area of a laser beam in which necessary intensity for the patterning is concentrated. Furthermore, since a pattern lacks clearness in the solar cell layer coming in contact with a circumference of a laser beam having a low intensity, when incident light is transmitted through the patterned surface, problems such as distortion of light transmission occur.

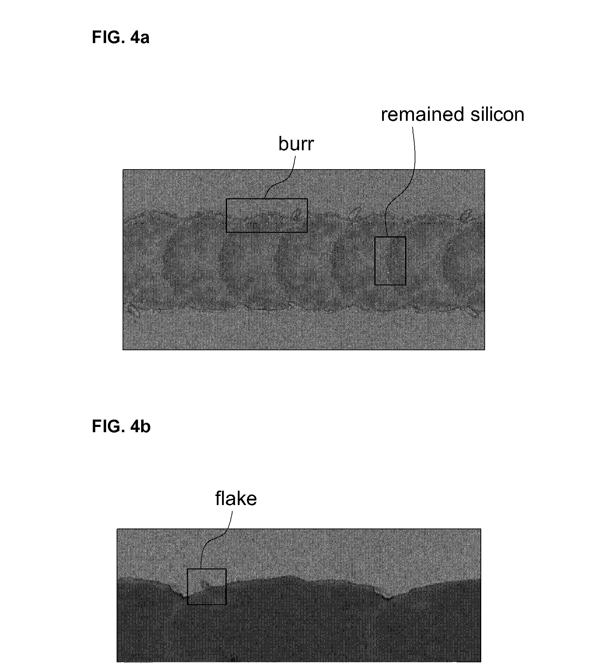

That is, as illustrated in FIG. 4A and FIG. 4B, when the pattern is formed on the solar cell layer 110 by a laser beam with a Gaussian intensity distribution, remained silicon, burr or flake occurs on a region of the solar cell layer 110 corresponding to a circumference of the laser beam.

When the intensity of the laser beam is increased to pattern a 'solar cell layer and the like' coming in contact with the circumference of the laser beam, the TCO 102 as well as the solar cell layer 110 corresponding to a central area of the laser beam is etched to distort the light transmitted through a substrate. Further, when the intensity of the laser beam is increased, a laser-induced transition phase from amorphous Si to microcrystalline Si may deteriorate an efficiency of the solar cell.

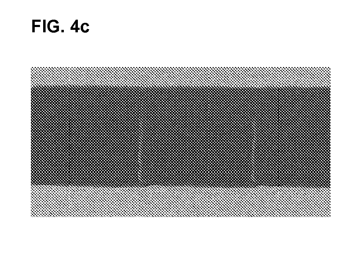

However, the laser beam with a Gaussian intensity distribution passes through the homogenizer 140 to homogenize an intensity of the laser beam. Accordingly, as illustrated in FIG. 4C, a pattern without any burr and flake may be formed.

The laser beam with the homogenized intensity distribution obtained by the homogenizer 140 passes through a mask 150. A pattern through which the laser beam selectively passes is formed on a surface of the solar module.

When the laser beam generated by the laser oscillator 110 passes through the mask 150, a pattern of the laser beam scanned to the solar module is determined. An example of available mask patterns determining the shape of the laser beam is shown in FIG. 5.

When the laser beam passes through the mask 150 with a pattern such as polygon or circle formed on the mask 150, one of a polygon or circle pattern formed on the mask 150 through which the laser beam passes is determined as a cross section pattern of the laser beam scanned to the solar module. However, in the embodiment, the pattern formed on the mask is limited to the pattern formed on the mask 150 shown in FIG. 5.

For example, the pattern formed on the mask 150 has at least one selected from the group consisting of the polygons and circles as shown in FIG. 5.

In the meantime, so as to form a pattern in the solar module, a pattern produced by the laser beam should be determined to prevent distortion of light transmitted through a substrate.

A mask having a plurality of patterns may be rotated to diversify shapes of a pattern formed on the solar module. For example, it is assumed that a triangular pattern and an elliptical pattern are formed on the mask as shown in FIG. 5. In order to form the triangular pattern on predetermined regions of 'solar cell layer and the like' in the solar module, the laser beam passes through the triangular pattern among patterns formed on the mask 150. Further, so as to form the elliptical pattern on other regions of 'solar cell layer and the like' in the solar module, the mask is rotated to pass the laser beam through the elliptical pattern among patterns formed on the mask 150.

When more than 3 patterns are formed on the mask 150, in the same manner, the mask 150 may be rotated to form a plurality of patterns on 'solar cell layer and the like' of the solar module at need.

The first total reflection mirror 191 in FIG. 1 reflects the laser beam passed through the mask 150 in a predetermined direction. A second total reflection mirror 192 reflects the laser beam reflected through the first total reflection mirror 191 to be incident to an inside of the scanner 160.

The scanner 160 scans the laser beam to a translucent insulation substrate of the solar module through a galvanometer mounted therein. The scanner 160 moves along an X axis, Y axis, or Z axis to form a pattern at the solar module with respect to the stage. A scanner moving device (not shown) is installed to move the scanner 160. When the scanner 160 moves along the X axis, Y axis, or Z axis with respect to the stage 180, the galvanometer 161 mounted in the scanner 160 also moves along the X axis, Y axis, or Z axis with respect to the stage 180. As the scanner 160 moves along the X axis, Y axis, or Z axis with respect to the stage 180, the galvanometer 161 moves along the X axis, Y axis, or Z axis with respect to the stage 180 to scan the laser beam to a predetermined region of a translucent insulation substrate of the solar module positioned on the stage 180.

The focusing lens 170 determines an image magnification of an image patterned on a substrate of the solar module by the laser beam provided from the scanner 160. The focusing lens 170 compensates distortion aberration occurring due to an optical path difference of the laser beam to the substrate through the galvanometer 161. Accordingly, a plurality of patterns formed on the substrate of the solar module are maintained constant in sizes.

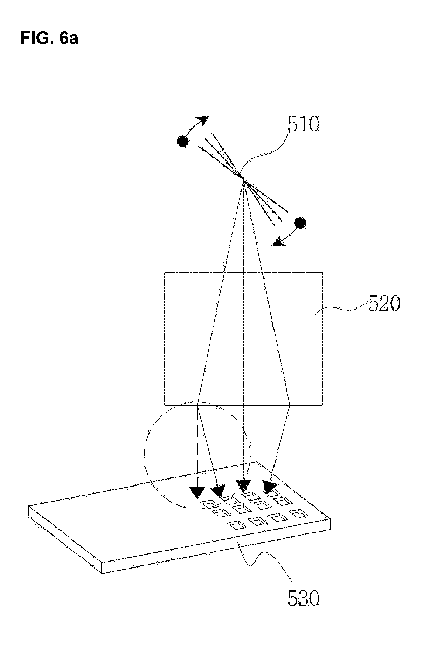

As shown in FIG. 6A, the laser beam is scanned on the substrate of the solar module through a galvanometer 510 and a focusing lens 520.

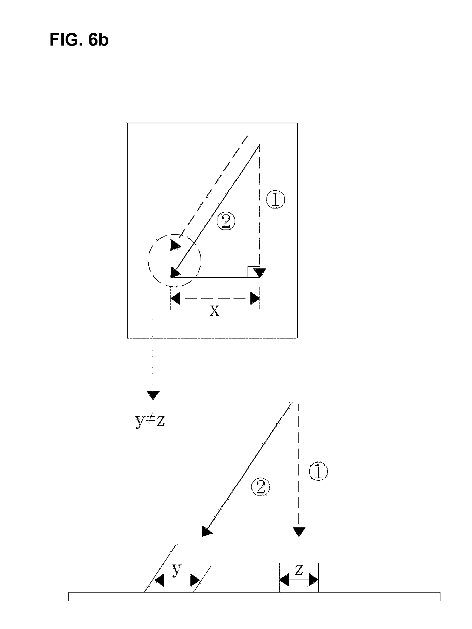

Referring to FIG. 6B, ① is a path of the laser beam vertically scanned on the substrate of the solar module from the focusing lens 520. ② is a path of the laser beam scanned on the substrate of the solar module from the focusing lens 520 in a non-vertical direction. In this case, a path difference occurs between ① and ②. Due to this, a difference occurs between regions y and z of the laser beam scanned on the substrate of the solar module.

When the difference occurs between regions y and z of the laser beam scanned on the substrate of the solar module, the plurality of patterns formed on the substrate of the solar module become non-uniform in sizes. This may exert a bad influence upon the light transmissivity of the BIPV module and total efficiency of the solar cell. Accordingly, the focusing lens 520 compensates distortion aberration occurring due to an optical path difference of the laser beam to maintain the sizes of plural patterns formed the substrate of the solar module constant.

The focusing lens 520 may comprise telecentric lenses. The focusing lens 520 compensates the distortion aberration by a combination of telecentric lenses.

The solar module is positioned on the stage 180 so that patterning is achieved by the laser beam provided from the focusing lens 520. The stage 180 moves along the X axis, Y axis, or Z axis by a moving device to pattern the solar module.

For example, a stage moving device (not shown) is described. The stage 180 is disposed on the stage moving device composed of an X axis guide rail, a Y axis guide rail, and a Z axis guide rail. Then, the X axis guide rail, the Y axis guide rail, and the Z axis guide rail are moved by a driver such as a motor to implement movement of the stage 180.

The following is a procedure of forming a pattern at a solar module to manufacture a module for BIPV by the solar module patterning apparatus 100 in accordance with an embodiment of the embodiment.

The laser beam with homogenized intensity distribution obtained by the homogenizer 140 passes through a pattern formed on the mask 150 to determine a cross section shape of the laser beam so that a worker's desired pattern shape may be patterned on a 'solar cell layer and the like' of the solar module.

When the scanner 160 moves to the X axis, Y axis, and Z axis with respect to the stage 180, the galvanometer 161 mounted in the scanner 160 also moves to the X axis, Y axis, and Z axis with respect to the stage 180. In this case, according to the movement of the scanner 160, the galvanometer 161 moves to the X axis, Y axis, or Z axis to scan the laser beam passed through the homogenizer 140 and the mask 150 to a predetermined region of the substrate of the solar module, thereby patterning the 'solar cell layer and the like'.

Moreover, when the laser beam is scanned on the 'solar cell layer and the like' on the substrate, the stage 180 on which the solar module is positioned moves along the X axis, Y axis, or Z axis to form a pattern at the 'solar cell layer and the like' of the solar module.

In this case, the laser beam may have a wavelength ranging from 1054 nm to 1074 nm or a wavelength ranging from 522 nm to 542 nm. The laser beam having the wavelength ranging from 1054 nm to 1074 nm may be homogenized by the homogenizer 140 to be used for formation of a pattern on the TCO 120 in FIG 3. The laser beam having the wavelength ranging from 522 nm to 542 nm may be also homogenized by the homogenizer 140 to form a pattern at the solar cell layer 110 in FIG. 3, or to simultaneously form a pattern at the solar cell layer 110, the transparent back reflector 104, and the rear electrode layer 103.

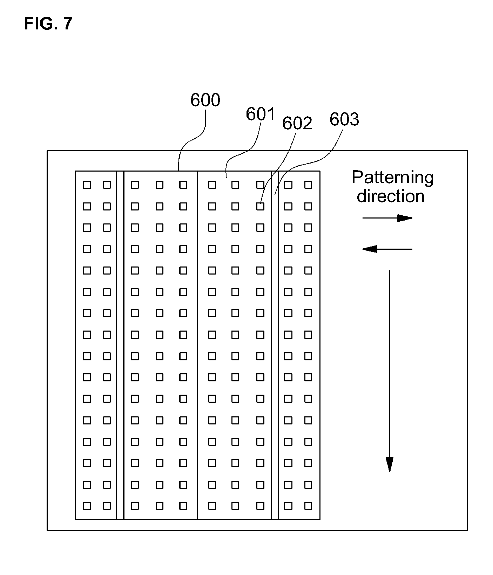

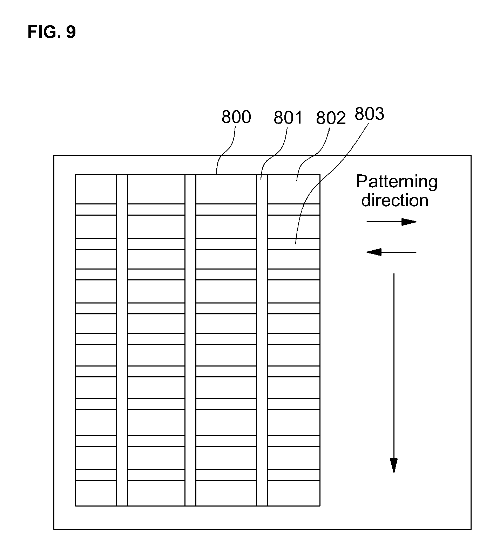

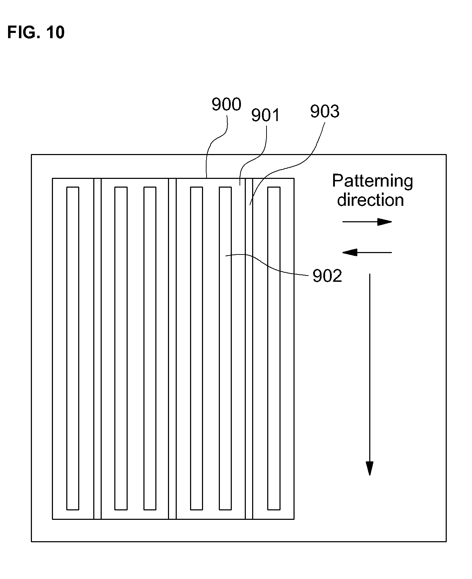

FIG. 7 to FIG. 10 are plan views illustrating an embodiment of a procedure that moves the scanner 160 and the stage 180 with respect to the laser beam passed through the homogenizer 140 and the mask to form a pattern at the 'solar cell layer and the like' of the solar module.

With reference to FIG. 7, unit solar cells 601 and insulation regions 603 are provided on the solar module 600. The insulation regions 603 insulate the unit solar cells 601 from each other. Patterns 602 are formed on each of the unit solar cells 610, which are obtained by forming a pattern at the 'solar cell layer and the like' by the solar module patterning apparatus of the embodiment. The scanner 160 and the stage 189 move in a direction of an arrow shown in FIG. 7 to form a pattern at the 'solar cell layer and the like' of the solar module.

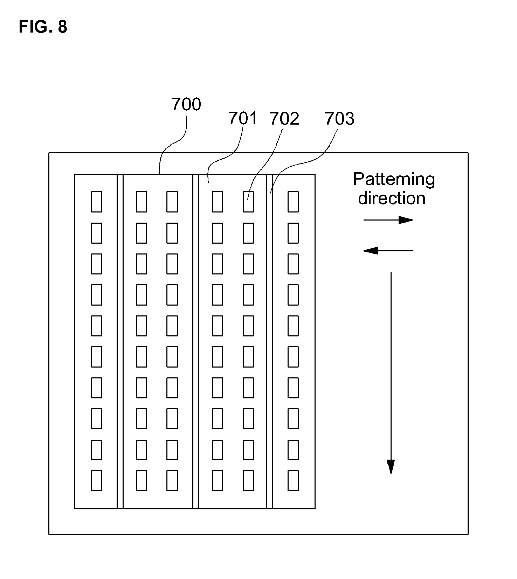

FIG. 8 to FIG. 10 show patterns obtained by forming a pattern at the 'solar cell layer and the like' by the solar module patterning apparatus in accordance with the embodiment in the same manner as that in FIG. 7.

Such patterning directions and shapes are shown in FIG. 7 to FIG. 10 by way of example only. However, the embodiment is not limited to the patterning directions and shapes shown FIG. 7 to FIG. 10.

[Second embodiment]

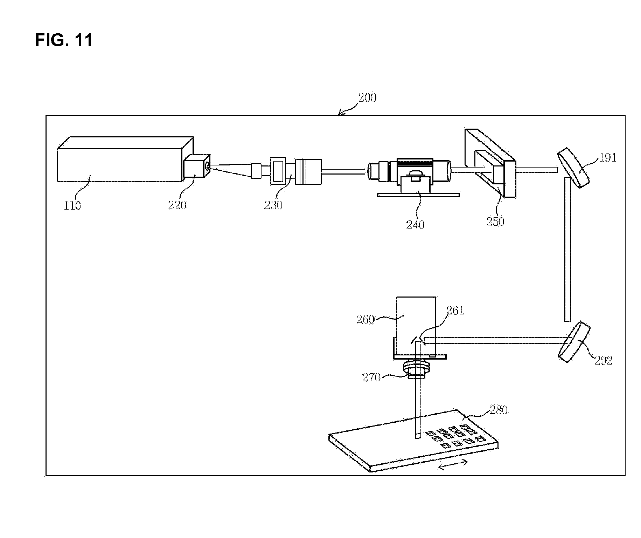

FIG. 11 is a schematic view illustrating a construction of a solar module pattering apparatus in accordance with the second embodiment.

As shown in FIG. 11, the solar module pattering apparatus in accordance with the second embodiment includes a laser oscillator 210, an regulator 220, a beam expander 230, a homogenizer 240, a mask 250, first and second total reflection mirrors 291 and 292, a scanner 260, a focusing lens 270, and a stage 280.

The solar module patterning apparatus in accordance with the second embodiment have substantially the same structural elements and operations thereof as those of the first embodiment described above. Differences of the second embodiment from the first embodiment will be explained below.

In the first embodiment, the laser beam passed through the regulator 120 is transferred to the homogenizer 140 through the optical fiber 130. In the second embodiment, a transfer of the laser beam passed through the regulator 220 to the homogenizer 240 does not use the optical fiber.

The laser beam generated by the laser oscillator 210 is emitted through the regulator 220.

The beam expander 230 converts a laser beam emitted through the regulator 220 into a parallel light. The beam expander 230 increases or reduces the size of a cross sectional area of the laser beam.

The laser beam passed through the beam expander 230 is transferred to the homogenizer 240. A remaining operation of the second embodiment is almost the same as that of the first embodiment and the description thereof is omitted.

## Claims

1. A solar module patterning apparatus comprising:
a laser oscillator (110; 210) generating a laser beam having a predetermined wavelength;
a homogenizer (140; 240) homogenizing an intensity distribution of the generated laser beam provided from the laser oscillator; and
a scanner (160; 260) scanning the laser beam to a solar module, the laser beam being output from the homogenizer and passed through a mask (150; 250) with a predetermined pattern.

2. The solar module patterning apparatus according to claim 1, further comprising a regulator (120) controlling an intensity of the generated laser beam provided from the laser oscillator.

3. The solar module patterning apparatus according to claim 2, further comprising:
an fiber coupler (131) connected to the regulator;
an optical fiber (130) connected to the fiber coupler; and
a fiber mount (132) connected to the optical fiber and the homogenizer.

4. The solar module patterning apparatus according to claim 1, further comprises an regulator (220) regulating an intensity of the generated laser beam provided from the laser oscillator and a beam expander (230) converting the laser beam passed through the regulator into a parallel light,
wherein the homogenizer homogenizes an intensity distribution of the generated laser beam provided from the beam expander.

5. The solar module patterning apparatus according to claim 1 or 4, further comprises a focusing lens (170; 270) compensating an image size error occurring due to an optical path difference of the laser beam passed through the scanner.

6. The solar module patterning apparatus according to claim 1 or 4, further comprises a stage (180; 280) on which the solar module is mounted to forming a pattern at the solar module by the laser beam passed through the scanner.

7. The solar module patterning apparatus according to claim 1 or 4, further comprises a stage on which the solar module is mounted to forming a pattern at the solar module by the laser beam passed through the scanner and a stage moving device moving the stage.

8. The solar module patterning apparatus according to claim 1 or 4, further comprises a focusing lens compensating an image size error occurring due to an optical path difference of the laser beam passed through the scanner,
and wherein the focusing lens comprises telecentric lenses.

9. The solar module patterning apparatus according to claim 1 or 4, wherein a galvanometer is mounted in the scanner, and the laser beam is scanned to the solar module through the galvanometer.

10. The solar module patterning apparatus according to claim 1 or 4, further comprises a scanner moving device moving the scanner.

11. The solar module patterning apparatus according to claim 1 or 4, further comprises a first total reflection mirror (191) reflecting the laser beam passed through the mask in a predetermined direction and a second total reflection mirror (192) reflecting the laser beam to be incident in the scanner.

12. The solar module patterning apparatus according to claim 1 or 4, further comprises a focusing lens compensating an image size error occurring due to an optical path difference of the laser beam passed through the scanner, and
wherein the focusing lens determines an image magnification of an image when the laser beam passed through the scanner is scanned on the solar module.

13. The solar module patterning apparatus according to claim 1 or 4, wherein a plurality of pattern are formed on the mask, and the laser beam passes through one of the plurality of patterns by a rotation of the mask.

14. The solar module patterning apparatus according to claim 1 or 4, wherein the laser beam has a wavelength ranging from 1054 nm to 1074 nm or from 522 nm to 542 nm.
